# FASCICULE DE BREVET EUROPEEN

(11) **EP 0 606 796 B1**
(45) Date de publication et mention de la délivrance du brevet: **04.03.1998**
(21) Numéro de dépôt: 93403063.6
(22) Date de dépôt: 16.12.1993
(51) Int. Cl.: G11C 16/06, G11C 29/00

(54) **Procédé de programmation en champ uniforme d'une mémoire électriquement programmable et mémoire mettant en oeuvre le procédé**
Verfahren zur uniformen Programmierung eines elektrisch programmierbaren Speichers und Speicher zur Durchführung des Verfahrens
Method of uniformly programming an electrically programmable memory and memory using the method

(30) Priorité: 31.12.1992 FR 9215993
(43) Date de publication de la demande: 20.07.1994
(73) Titulaire: SGS-THOMSON MICROELECTRONICS S.A., 94250 Gentilly (FR)
(72) Inventeur: Rouy, Olivier, Cabinet Ballot-Schmit, F-94230 Cachan (FR)
(74) Mandataire: Ballot, Paul

(56) Documents cités:
- GB-A- 2 215 155
- PATENT ABSTRACTS OF JAPAN vol. 16, no. 551 (P-1453)20 Novembre 1992 & JP-A-42 006 094 (MITSUBISHI ELECTRIC CORP) 28 Juillet 1992

## Description

La présente invention concerne un procédé de programmation en champ uniforme d'une mémoire électriquement programmable. Elle s'applique aux mémoires comportant une interface dynamique de commande, notamment aux mémoires de type flash EPROM.

La présente invention concerne aussi une mémoire mettant en oeuvre un tel procédé.

Les mémoires à interface dynamique de commande comportent la circuiterie interne nécessaire à assurer le séquencement interne de certaines opérations sur la mémoire, comme par exemple la programmation. Les mémoires flash EPROM ont une telle structure.

Rappelons qu'une mémoire flash EPROM est constituée de cellules à grille flottante ayant un oxyde de grille d'épaisseur faible de l'ordre de 0,1 micromètre et uniforme au-dessus du canal de conduction. La programmation des cellules se fait par électrons chauds. L'effacement global de la mémoire se fait par effet tunnel.

Ces différentes opérations utilisent des niveaux de tensions différents sur les grilles, sources et drains et des durées particulières d'application de ces niveaux. Chacune peut être suivie d'une opération de vérification consistant en une lecture des cellules programmée ou effacées, avec des niveaux de tension de lecture plus élevés qu'en lecture normale, permettant d'assurer une grande fiabilité aux opérations de programmation et d'effacement.

C'est pour simplifier l'utilisation de telles mémoires qu'une architecture à registre de commande a été proposée.

Les mémoires de type flash EPROM comportent ainsi un registre de commande pour recevoir des codes instructions et de la circuiterie pour séquencer les tâches correspondantes.

D'une manière générale, les signaux externes utilisés sont un signal d'autorisation d'écriture, /WE, un signal de validation de la sortie des données en lecture, /OE, des signaux de données, par exemple D0-D7, des signaux d'adresses, par exemple A0-A15, une tension d'alimentation VCC, une haute tension VPP et la masse VSS.

Par convention, les signaux /OE et /WE sont actifs à l'état bas.

Le circuit mémoire attend comme premier cycle, un cycle d'écriture d'un code instruction. Ceci se fait avec le signal /OE à l'état inactif ce qui invalide la sortie de données sur les signaux D0-D7, en activant le signal /WE pour autoriser l'écriture, et en présentant sur les signaux externes de données D0-D7 un code instruction qui est mémorisé dans le registre de commande.

Dans le cas d'une instruction de programmation d'une donnée à une adresse mémoire, le circuit attend alors comme prochain cycle, un cycle d'écriture de la donnée et de l'adresse. La programmation est alors déclenchée.

Le circuit mémoire attend ensuite un nouveau cycle d'écriture du code instruction de vérification de la programmation. Cette écriture a pour effet de stopper la programmation. Le signal /OE est au niveau actif pour permettre la sortie sur les signaux de données D0-D7, d'une information indiquant la réussite ou non de la programmation.

La durée de la programmation est contrôlée par le deuxième cycle d'écriture de la donnée à programmer qui commande le début de la programmation, et le troisième cycle d'écriture du code instruction de vérification qui commande l'arrêt de la programmation.

Dans le cas d'une instruction d'effacement, la séquence de commande est similaire mais aussi plus simple du fait que l'effacement concerne tout le plan mémoire (ou un secteur quand le plan est segmenté) et non des adresses de mot particulières.

Cependant l'effacement du plan mémoire nécessite au préalable que tout le plan mémoire soit programmé, de manière à assurer un effacement uniforme et fiable de la mémoire. Si l'effacement consiste par convention à mettre les cellules mémoire à l'état logique "1" et la programmation à l'état logique "0", il est donc nécessaire de programmer toute la mémoire en champ uniforme de zéro ("0").

Le temps cumulé des séquences de commande de programmation pour tout le plan mémoire devient alors particulièrement important, puisque, comme on l'a vu, il nécessite trois cycles d'écriture pour chaque adresse mémoire.

Pour les mémoires de forte capacité, ce temps nécessaire à la programmation en champ uniforme est particulièrement pénalisant pour l'utilisateur.

Le fabricant lui-même est pénalisé pour ses procédures de test d'effacement, mais aussi plus généralement pour la détection de défauts pour lesquelles on utilise souvent des programmations en champ uniforme avec des états logiques complémentaires pour deux cellules adjacentes dans un mot (test dit en damiers avec programmation de chaque octet mémoire avec par exemple la donnée 55H ). Or on sait que les coûts des tests sont très élevés.

L'invention se propose de résoudre ce problème avec un autre procédé pour la programmation en champ uniforme qui permet de réduire le nombre de cycles d'écriture nécessaires.

Dans l'invention, on a eu l'idée de n'écrire qu'une seule fois la donnée à programmer, pour la programmation de la première adresse, et de la mémoriser pour programmer les adresses suivantes.

Une autre idée de l'invention est de n'écrire qu'une seule fois le code instruction de programmation en champ uniforme. La durée de la programmation et la prise en compte des adresses successives sont séquencées à l'aide du seul signal de validation /OE. Ainsi, il n'y a plus que deux cycles d'écriture /WE au début de la séquence, ensuite seuls le signal de validation /OE et les signaux d'adresses A0-A15 ont à être gérés.

Telle qu'elle est revendiquée, l'invention concerne donc un procédé de programmation d'une donnée dans une mémoire électriquement programmable en circuit intégré comportant un bus d'entrée/sortie de données, un bus d'adresse, un registre de commande de modes de séquencement d'instructions et un signal de validation (/OE), ce signal validant le bus de sortie de données sur un état actif.

Selon l'invention, lorsque le registre de commande reçoit une instruction de programmation uniforme, il envoie un signal de mode de séquencement de programmation uniforme pour qu'un état inactif du signal de validation commande la programmation de la donnée à une adresse mémoire présente sur le bus d'adresse et que l'état actif du signal de validation commande l'arrêt de la programmation.

L'invention concerne aussi une mémoire électriquement programmable en circuit intégré comportant un bus d'adresse, un bus d'entrée/sortie de données et un registre de commande de mode de séquencement d'instruction, et recevant un signal de validation /OE, ce signal validant le bus de sortie de données sur un état actif et un signal d'autorisation d'écriture /WE pour générer une horloge de mémorisation de données dans un registre de données, une horloge de mémorisation d'adresse dans un décodeur de la mémoire et une horloge I-CLK de mémorisation d'instructions dans le registre de commande.

Selon l'invention, la mémoire comporte des moyens pour délivrer un signal de commande de programmation uniforme recevant en entrée un signal de mode de programmation uniforme, l'horloge de mémorisation de données et le signal de validation /OE et délivrant en sortie un niveau actif du signal de commande de programmation uniforme sur un niveau inactif du signal de validation /OE et un niveau inactif du signal de commande de programmation uniforme sur un niveau actif du signal de validation, le signal de mode de programmation uniforme étant délivré par le registre de commande.

D'autres caractéristiques et avantages sont présentés dans la description détaillée qui suit faite à titre indicatif et nullement limitatif de l'invention, et en référence aux dessins annexés dans lesquels :
- la figure 1 est un schéma bloc d'une mémoire flash EPROM permettant la mise en oeuvre du procédé de programmation uniforme selon l'invention.
- la figure 2 est un diagramme des temps d'une séquence de programmation normale de la mémoire de la figure 1.
- la figure 3 est un diagramme des temps d'une séquence de programmation uniforme selon l'invention.

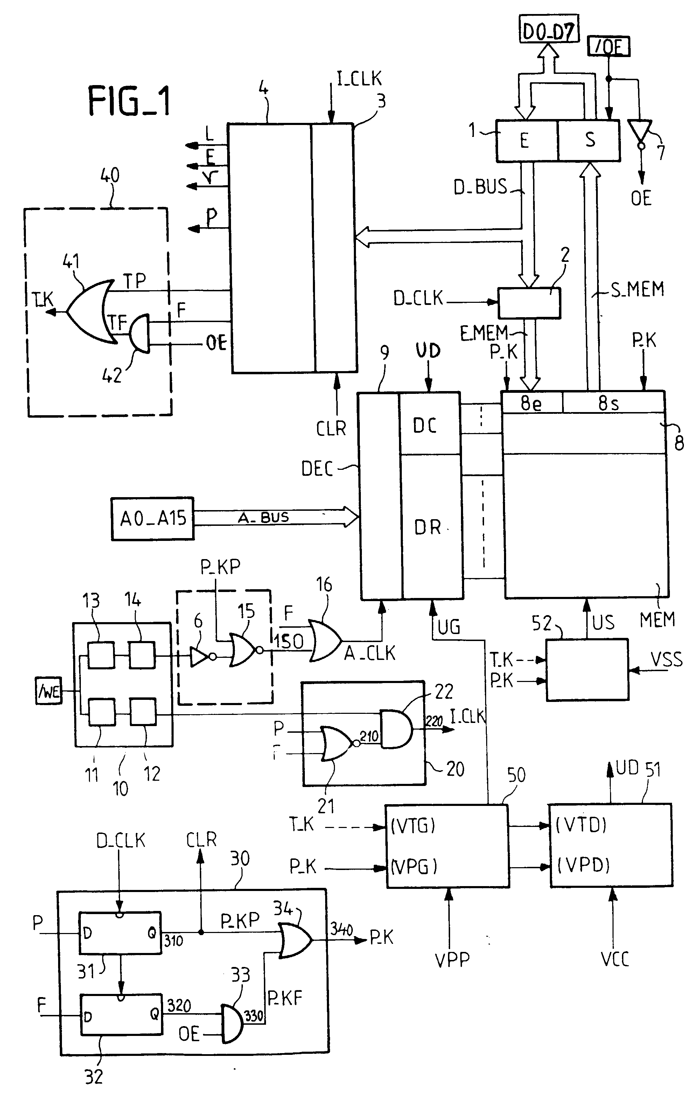

La figure 1 représente un circuit mémoire dont l'architecture permet de mettre en oeuvre le procédé de l'invention.

Dans l'exemple, il correspond à un circuit mémoire comprenant un plan mémoire MEM de type flash EPROM électriquement programmable et électriquement effaçable. Il peut être utile de faire quelques rappels. Un plan mémoire est organisé en rangées et colonnes. Toutes les cellules d'une même rangée ont la même grille. Toutes les cellules d'une même colonne ont le même drain. Les sources des cellules sont réunies ensemble à un noeud commun du circuit. L'accès à une cellule se fait en appliquant une tension UG sur la rangée connectée à la grille de cette cellule, une tension UD sur la colonne connectée au drain de cette cellule et une tension US sur le noeud commun des sources.

La lecture d'une cellule Flash EPROM est ainsi obtenue en appliquant sur la rangée une tension de grille UG de l'ordre de 5 volts (VCC), sur la colonne, une tension de drain UD de l'ordre de 1 volt et sur le noeud commun des sources du plan mémoire, une tension US égale à zéro volt (VSS). Le contenu de la cellule est lu sur la colonne.

La programmation d'une cellule flash EPROM est obtenue en appliquant sur la rangée une tension de grille UG égale à environ 12 volts (VPP), sur la colonne une tension de drain UD de l'ordre de 6 volts, et au noeud commun des sources du plan mémoire, une tension de source US égale à zéro volts (VSS).

L'effacement est obtenu en appliquant une tension de grille UG égale à la masse VSS, la colonne étant non connectée et la tension de source US à environ 9 volts.

Une lecture de vérification est de préférence effectuée après une opération d'écriture ou de programmation. Cette lecture se fait avantageusement à une tension de grille UG plus élevée qu'en lecture normale, de l'ordre de 7 volts.

Les circuits bien connus de génération des commandes de lecture et d'effacement qui ne sont pas notre propos ne seront pas détaillés.

Dans la suite, on s'intéresse plus particulièrement à la programmation, spécialement au procédé de programmation uniforme selon l'invention, et à la possibilité de lecture de vérification après programmation.

Un circuit mémoire reçoit principalement comme signaux externes :
- les signaux d'entrée/sortie de données, D0-D7 dans l'exemple de la figure 1,
- les signaux d'adresse, A0-A15 dans l'exemple.
- le signal /OE de validation du bus de sortie S-MEM de lecture de données de la mémoire sur les signaux externes d'entrée/sortie D0-D7, actif à l'état bas ("0" logique).
- le signal /WE d'autorisation d'écriture, actif à l'état bas. Une impulsion négative de ce signal permet la génération d'horloges de mémorisation des données, adresses et instructions. Dans la suite, l'expression "cycle d'écriture" correspond à la génération d'une impulsion active (donc négative) sur le signal /WE.

Les signaux externes d'entrée/sortie D0-D7 arrivent d'une part en entrée E d'un registre 1 qui délivre le bus d'entrée de données interne du circuit noté D-BUS. Le registre 1 reçoit d'autre part le bus de sortie de données S-MEM du plan mémoire MEM, pour délivrer en sortie S du registre, une donnée lue en mémoire, sous contrôle du signal de validation /OE. Cette sortie S est reliée aux sorties D0-D7. Le signal de validation des sorties /OE autorise à l'état actif (/OE= 0), la transmission du bus de sortie S-MEM de la mémoire sur la sortie S du registre 1. A l'état inactif (/OE=1), la sortie S est mise à un état flottant : Elle n'impose pas d'états logiques sur les signaux externes D0-D7.

Le bus d'entrée de données D-BUS est connecté en entrée d'un registre 2 de mémorisation de données dont la sortie notée E-MEM est reliée au circuit d'entrée de programmation 8e associé au circuit 8 de portes de commande des lignes de bit ou colonnes du plan mémoire MEM. Le registre 2 de mémorisation de données reçoit un signal d'horloge D-CLK qui provoque, sur une impulsion, la mémorisation d'une donnée présente sur le bus de données D-BUS. Le circuit d'entrée 8e comporte notamment, de manière connue, des amplificateurs d'écriture (non représentés).

Le circuit de portes de commande 8 est, par ailleurs, associé à un circuit de sortie 8s comprenant des amplificateurs de lecture et des registres de sortie et qui délivre la sortie S-MEM du plan mémoire.

Les signaux d'adresse A0-A15 sont transmis en interne sur le bus d'adresse A-BUS, connecté au décodeur d'adresse DEC du plan mémoire. Ce décodeur comporte classiquement un décodeur DR d'adresse de rangée (ou ligne de mot), un décodeur d'adresse de colonne DC (ou ligne de bit) et un registre de mémorisation d'adresse 9.

Ce registre 9 reçoit en entrée le bus d'adresse A-BUS, et un signal d'horloge A-CLK. Une impulsion de ce signal provoque la mémorisation de l'adresse présente sur le bus d'adresse dans le registre 9 et le décodage de cette adresse par les décodeurs DR et DC.

Le décodeur DR reçoit en entrée une commande en tension de grille UG qu'il applique sur la rangée désignée par l'adresse décodée, les autres rangées étant maintenues par exemple à la masse VSS.

Le décodeur DC reçoit en entrée une commande en tension de drain UD qu'il applique aux colonnes désignées par l'adresse décodée, les autres colonnes étant, par exemple, non connectées. On rappelle que l'adresse d'un mot du plan mémoire désigne une seule rangée et une ou plusieurs colonnes. Le nombre de colonnes désignées correspond au nombre de bits de données d'un mot mémoire. Dans l'exemple où la donnée est sur 8 bits (octet), une adresse d'un mot mémoire désigne 1 rangée et 8 colonnes, chaque colonne étant associée à un bit de poids déterminé du mot de données. Pour la programmation d'un mot mémoire avec une donnée, la tension de programmation ne sera appliquée que sur les colonnes dont la valeur du bit correspondant dans la donnée à programmer prend la valeur dite de programmation. Dans un exemple, si l'état programmé d'une cellule est l'état logique 1, si la donnée à programmer est égale à 55 H (hexadécimal), seules les colonnes associées aux bits de poids 0, 2, 4 et 6 se verront appliquer la tension de programmation.

Le décodeur DC n'applique donc pas directement la tension de grille UG sur les colonnes. Il l'applique à travers le circuit de programmation de données 8e et le circuit de portes 8 de commande des colonnes. Le circuit de programmation de données 8e est sélectionné pendant la programmation d'une adresse de la mémoire avec une donnée D stockée dans le registre de données 2. Il reçoit cette donnée sur le bus E-MEM de sortie du registre 2. Le circuit de portes 8 est commandé en programmation par le décodeur DC pour sélectionner les colonnes adressées et par le circuit de programmation de données 8e pour ne programmer que les colonnes désignées par la donnée D.

Hors programmation, c'est le circuit de sortie 8s qui est sélectionné par défaut, le circuit d'entrée 8e étant alors désélectionné.

Le fonctionnement d'une telle mémoire est contrôlé par un registre de commande 3 et des circuits de séquencement de tâches.

Le registre de commande 3 reçoit en entrée le bus de données D-bus, un signal d'horloge I-CLK et un signal de mise à zéro CLR. Il comprend un décodeur 4 qui délivre un niveau actif (=1) sur la sortie de mode de fonctionnement associée à l'instruction mémorisée dans le registre de commande sur une impulsion d'horloge I-CLK. Le signal de mise à zéro CLR est dans l'exemple actif à 1, et remet à zéro toutes les sorties du registre de commande. Dans l'exemple, 5 sorties de commande sont prévues :
- une sortie L de mode de lecture, correspondant à un code instruction IL,
- une sortie E de mode d'effacement, correspondant à un code instruction IE,
- une sortie V de mode de vérification après effacement, correspondant à un code instruction IV,
- une sortie P de mode de programmation normale, correspondant à un code instruction IP,
- une sortie T de mode de vérification après programmation, correspondant à un code instruction IT,
- une sortie F de mode de programmation uniforme rapide correspondant à un code instruction IF, qui est prévue selon l'invention.

Les modes de lecture, effacement et vérification après effacement ne sont indiqués que pour mémoire. On s'intéresse dans la suite aux modes de programmation normale ou uniforme selon l'invention.

Un premier circuit 50 de commande de la tension de grille UG reçoit en entrée d'une part, le signal de commande de programmation P-K et dans l'exemple représenté, le signal de commande de vérification de programmation T-K. Il commute sur sa sortie UG la tension correspondant à la commande active en entrée, tension qu'il génère à partir des tensions externes.

Dans l'exemple de la flash EPROM, où la tension de grille de programmation VPG est de 12 volts et la tension de grille de vérification de programmation VTG est de 7 volts, la tension externe utilisée par le circuit 50 pour générer les tensions VPG et VTG est la haute tension VPP (12 volts). Les circuits bien connus de génération de tension ne seront pas détaillés.

Un deuxième circuit 51 de commande de la tension de drain UD reçoit en entrée les mêmes signaux de commande. Il génère les tensions de drains correspondantes de programmation VPD (5 volts) et de vérification de programmation VTD (1 volt) dans l'exemple à partir de la tension d'alimentation VCC (5 volts) du circuit et commute sur sa sortie UD la tension associée au niveau de commande actif en entrée.

Enfin un troisième circuit 52 de commande de la tension de source US du plan mémoire reçoit en entrée les mêmes signaux de commande P-K et T-K et, dans le cas représenté d'une mémoire flash EPROM, la tension VSS de masse du circuit. C'est cette tension VSS qui est commutée sur la sortie US dans les deux cas (programmation ou vérification de programmation).

La circuiterie interne doit générer des signaux d'horloge pour assurer les différents séquencements. D'une manière connue, ces signaux sont :
- un signal d'impulsions d'horloge D-CLK pour mémoriser les données dans le registre 2 de données associé à la mémoire. Une impulsion D-CLK est générée sur chaque front montant du signal d'autorisation d'écriture /WE. A chaque impulsion de ce signal d'horloge D-CLK, les données présentes sur le bus de données D-BUS sont mémorisées dans le registre 2 de données.
- un signal d'impulsions d'horloge A-CLK, pour mémoriser les adresses dans le décodeur DEC. Une impulsion A-CLK est générée sur chaque front descendant du signal de validation d'écriture /WE. A chaque impulsion de ce signal d'horloge A-CLK, l'adresse présente sur le bus d'adresse A-BUS est mémorisée dans le décodeur d'adresse DEC de la mémoire.
- un signal d'impulsions d'horloge I-CLK, pour mémoriser les instructions. A chaque impulsion de ce signal d'horloge I-CLK, la donnée (qui est un code instruction) présente sur le bus de données D-BUS est mémorisée dans le registre de commande. Une impulsion I-CLK est générée sur chaque impulsion du signal d'horloge D-CLK, si le mode de programmation P n'est pas activé ou si le mode de programmation uniforme F selon l'invention n'est pas activé. En effet, une commande d'instruction de programmation normale ou uniforme selon l'invention est nécessairement suivie d'un cycle d'écriture de la donnée à programmer. Il ne faut donc pas que cette donnée soit mémorisée dans le registre de commande.

Pour générer ces différents signaux d'horloge, le signal d'autorisation d'écriture /WE est appliqué en entrée d'un circuit 10 de génération des horloges A-CLK et D-CLK.

Ce circuit 10 comprend de manière connue:
- un circuit 11 de détection du front montant du signal /WE en série avec un premier monostable 12 pour délivrer le signal d'horloge D-CLK.
- un circuit 13 de détection de front descendant du signal /WE en série avec un deuxième monostable 14. Ce monostable 14 délivre une sortie 140 connectée en entrée d'un inverseur 6 en série avec une entrée d'une porte NON-OU 15 qui reçoit comme autre entrée le signal de commande de programmation normale P-KP.

Selon l'invention, la sortie 150 de cette porte NON-OU 15 est connectée sur une entrée d'une porte 16 OU. L'autre entrée de cette porte 16 reçoit le signal de mode de programmation en champ uniforme F. La sortie de la porte 16 OU délivre le signal d'horloge A-CLK.

Cette porte 16 permet de forcer le signal d'horloge A-CLK au niveau haut (A-CLK=1), quand le mode de programmation en champ uniforme est activé (F=1). L'adresse présente dans le décodeur de la mémoire est alors l'adresse présente au même moment sur le bus d'adresse A-BUS.

Le signal d'horloge I-CLK est normalement une recopie du signal d'horloge de mémorisation des données D-CLK, sauf en programmation (normale ou uniforme) où il doit être inhibé. Un circuit 20 de génération du signal d'horloge I-CLK comporte ainsi une porte NON-OU 21 qui reçoit en entrée les signaux de mode de programmation normale P et uniforme F et dont la sortie 210 est connectée en entrée sur une porte 22 ET. Cette porte 22 reçoit sur une autre entrée le signal d'horloge D-CLK. La porte 22 délivre en sortie 220 le signal d'horloge I-CLK. Ce circuit logique 20 permet, en mode de programmation normale (P=1) ou en mode de programmation uniforme selon l'invention (F=1), d'empêcher la recopie des impulsions D-CLK sur le signal d'horloge I-CLK.

Un circuit 30 de génération de la commande de programmation P-K comporte de manière connue une première bascule 31 qui reçoit en entrée le signal P de mode de programmation normale, et l'horloge de mémorisation des données D-CLK. Elle délivre sur sa sortie 310 le signal CLR de remise à zéro du registre de commande 3 et le signal de commande de programmation normale P-KP.

Selon l'invention, le circuit 30 de génération du signal de commande de programmation comporte une deuxième bascule 32. Cette bascule reçoit en entrée le signal de mode F de programmation uniforme et le signal d'horloge D-CLK. Sa sortie 320 est connectée sur une entrée d'une porte 33 ET, dont l'autre entrée reçoit le signal de validation de sortie /OE. Cette porte 33 ET délivre sur sa sortie 330 le signal de commande de programmation uniforme P-KF.

Les sorties 310 de la première bascule 31 et 330 de la porte 33 ET sont connectées en entrée d'une porte 34 OU dont la sortie 340 délivre le signal P-K de commande de programmation de la mémoire.

Un circuit 40 de génération de la commande de vérification après programmation T-K comporte une porte 41 OU recevant en entrées le signal de mode de vérification de programmation normale TP et le signal de mode de vérification de programmation uniforme TF. Il délivre en sortie le signal de commande de vérification de programmation T-K qui commande l'application des tensions de lecture en vérification VTG et VTD, respectivement de l'ordre de 7 volts et 1 volt pour une mémoire flash EPROM. (Dans le cas où la vérification se fait à des tensions de lecture normales, la tension de grille UG est alors de 5 volts).

Le signal de mode de vérification de programmation uniforme TF est délivré par la sortie d'une porte 42 ET qui reçoit en entrée le signal de mode de programmation uniforme F délivré par le registre de commande 3 et le signal de validation inversé OE. Dans ce cas, la commande de programmation T-K est donc active sur le niveau actif du signal de validation /OE, niveau qui permet la sortie S-MEM de la donnée ST lue en mémoire sur les signaux de données D0-D7.

Dans le cas de l'activation du signal de mode de vérification de programmation normale TP, le signal de commande de programmation T-K est la recopie du signal de mode TP. En général, on attend alors quelques microsecondes pour activer le signal de validation /OE en sortie, le temps que la lecture soit effectuée.

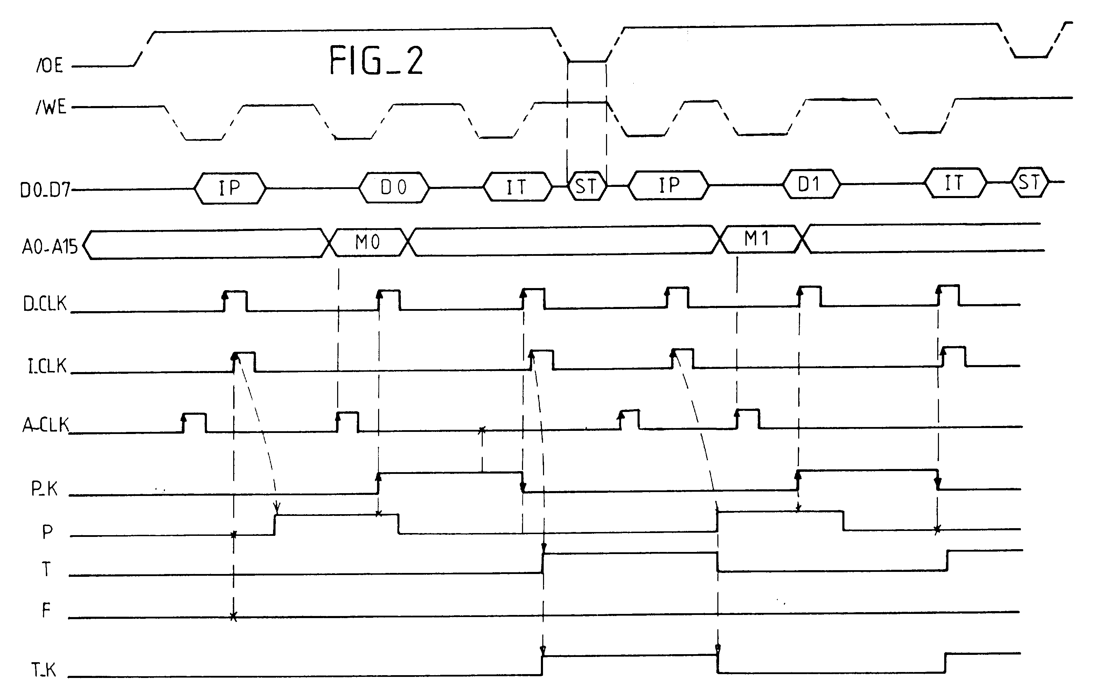

On va maintenant décrire le fonctionnement d'une telle mémoire. Le diagramme de temps de la séquence de programmation normale est représenté sur la figure 2. Le registre de commande 3 reçoit le code instruction IP de programmation normale dans un premier cycle d'écriture (1), (impulsion négative sur le signal /WE), le signal de validation étant au niveau inactif (/OE=1), ce qui invalide la sortie de données. Le registre de commande 3 active le signal de mode P à 1. Dans un deuxième cycle d'écriture (2), une donnée D0 est mémorisée dans le registre 2 de données, et une adresse M0 est mémorisée dans le registre 9 du décodeur. Le signal d'horloge I-CLK est inactif (circuit 20). La bascule 31 délivre alors un niveau actif égal à 1 sur sa sortie. Ce niveau actif commande d'une part le début de la programmation: les signaux P-KP et P-K passent à 1, ce qui commande l'application des tensions de programmation sur l'adresse mémoire M0. D'autre part, ce niveau actif commande la remise à zéro CLR du registre de commande 3: le signal de mode P repasse à zéro. Un troisième cycle (3) d'écriture génère une nouvelle impulsion D-CLK. Mais l'impulsion A-CLK est inhibée (portes 6, 15) car la commande de programmation normale PK-P est active. Cela permet de maintenir l'adresse programmée dans le décodeur. Comme le signal de mode P est à 0, la bascule 31 délivre un niveau 0 en sortie et donc le signal de commande de programmation P-K repasse à zéro: la programmation de l'adresse M0 avec la donnée D0 est terminée. Une séquence de programmation d'une adresse comporte ainsi 3 cycles d'écriture (1), (2) et (3). La durée de la programmation est commandée par les deux derniers cycles d'écriture.

Avantageusement, on prévoit après chaque programmation normale d'une adresse mémoire de vérifier cette programmation. L'instruction IT de vérification de programmation normale est ainsi écrite dans le registre de commande 3 pendant le troisième cycle d'écriture (3). Ce troisième cycle génère en effet une impulsion I-CLK, puisqu'au deuxième cycle d'écriture, le signal de mode P a été remis à zéro (circuits 20 et 30). Le mode de vérification de programmation est alors activé T=TP=1, et une commande de vérification T-K est activée par la recopie du signal de mode TP. Cette commande est une lecture de l'adresse mémoire qui vient d'être programmée, et qui est encore présente au troisième cycle d'écriture (3) dans le registre 9 du décodeur, l'impulsion A-CLK étant inhibée au troisième cycle d'écriture par la porte 15. Sur activation du signal de validation/OE (/OE = 0) la donnée lue ST sort en sortie S-MEM de la mémoire et sur les signaux de données externes D0-D7. On attend, en général, quelques microsecondes entre l'activation de la commande T-K et celle du signal de validation /OE, le temps que la lecture soit effectuée (temps de commutation des tensions...).

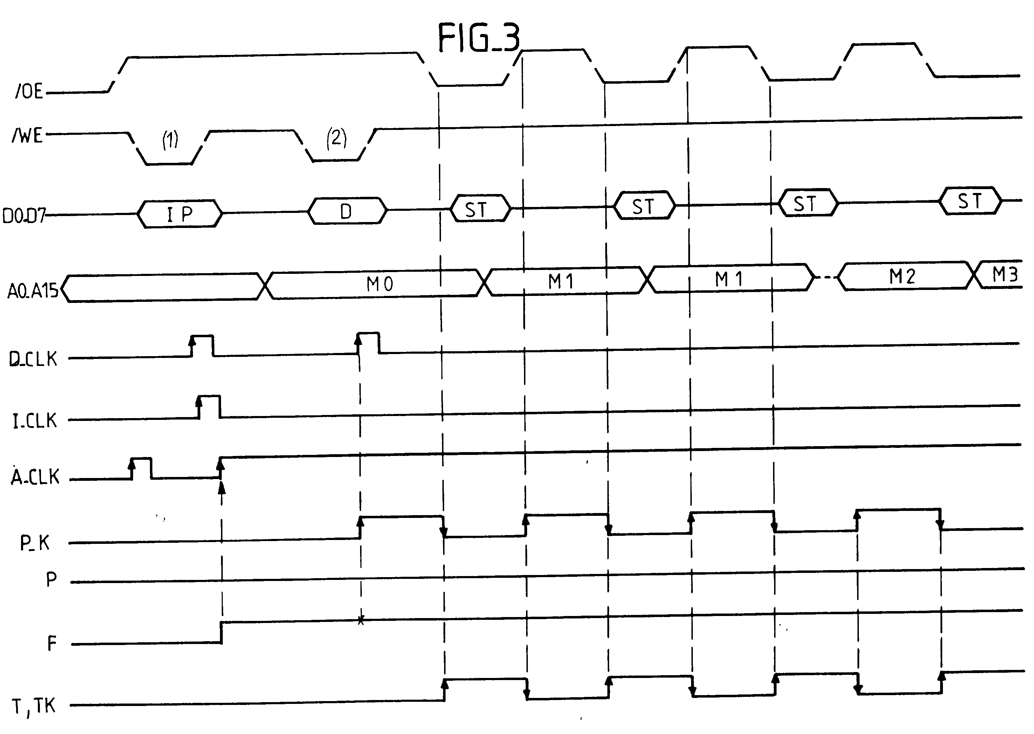

Le diagramme de temps de la séquence de programmation uniforme, est représenté sur la figure 3. Le registre de commande 3 reçoit le code instruction de programmation uniforme IF dans un premier cycle d'écriture (1), le signal de validation étant au niveau inactif (/OE=1). Le registre de commande 3 active le signal de mode F à 1. Ce signal de mode F force alors le signal d'horloge A-CLK au niveau haut, ce qui rend le bus d'adresse transparent pour le décodeur DEC de la mémoire. Le signal d'horloge I-CLK est lui forcé au niveau bas inactif. Dans un deuxième cycle d'écriture, une donnée D est mémorisée dans le registre 2 de données et une adresse M0 présentée et maintenue sur le bus d'adresse A-BUS est décodée par le décodeur DEC. La bascule 32 délivre un niveau actif en sortie. Comme le signal de validation /OE est à 1 (niveau inactif), la sortie de la porte 33 commande un niveau haut sur le signal de commande de programmation P-K, ce qui commande l'application des tensions de programmation à l'adresse M0. Le passage au niveau bas actif du signal de validation /OE entraîne le passage à zéro de la commande P-K (porte 33) : la programmation est arrêtée. Une nouvelle adresse M1 peut être positionnée et maintenue sur le bus d'adresse. Le passage au niveau inactif du signal de validation /OE va commander la programmation de cette adresse M1 avec la donnée D toujours mémorisée dans le registre 2 de données. En résumé, la séquence de programmation uniforme comporte deux cycles d'écriture : un premier pour activer le mode (F), un deuxième pour mémoriser la donnée à programmer et positionner la première adresse. Ensuite, c'est le signal de validation /OE qui commande la programmation des adresses présentées sur son niveau actif (/OE=1).

On remarque que la nouvelle adresse à programmer doit être établie avant que le signal de validation /OE soit inactif, c'est-à-dire avant que la programmation de cette nouvelle adresse débute. Elle doit donc être positionnée pendant le niveau actif du signal de validation /OE. Mais en cas de vérification de programmation, elle doit être positionnée après la lecture de vérification de la programmation précédente. Le changement d'adresse se fait donc pendant que le signal de validation /OE est actif (/OE=0) et un peu avant qu'il ne devienne inactif (/OE=1). Les temps d'établissement des données et adresses ne seront pas plus détaillés.

Dans le cas de la programmation uniforme, on peut remarquer que le temps de programmation est contrôlé par la durée entre deux impulsions actives du signal de validation /OE.

Les séquences de programmation normale et en champ uniforme décrites avec vérification après programmation correspondent au cas préféré de programmation par approche successive. Dans ce cas, le temps de programmation est relativement court (environ 10 microsecondes), et il est possible de reprogrammer plusieurs fois la même adresse, si la donnée ST lue après programmation n'est pas suffisante. Cette méthode bien connue de programmation permet d'approcher au mieux un seuil de tension de conduction déterminé des cellules programmées. On augmente ainsi la fiabilité (cellules moins stressées) et la rapidité de la programmation.

Mais il est possible d'utiliser une programmation avec un temps délibérément long, déterminé selon la technologie de la mémoire, au bout duquel on est certain que les cellules mémoire sont programmées. Dans ce cas l'utilisateur peut ne pas faire de vérification. Alors dans la séquence de programmation en champ uniforme selon l'invention notamment, il n'y aura pas de lecture de l'adresse programmée. Les circuits logiques associés à ce mode de vérification , référencés 40, 41, 42 et 15 et représentés en pointillés dans l'architecture de la mémoire sur la figure 1 ne seront pas utilisés. Mais le procédé de programmation uniforme utilisant le signal de validation /OE pour commander et arrêter la programmation s'applique de la même façon.

Dans le procédé selon l'invention, on initialise la programmation en champ uniforme dans un premier cycle d'écriture. Dans un deuxième cycle d'écriture, on débute la programmation d'une première adresse présentée et maintenue sur le bus d'adresse avec la donnée à programmer mémorisée dans le registre 2 de données associé à la mémoire. Puis on utilise seulement le signal de validation /OE et les signaux d'adresse pour arrêter la programmation et présenter une nouvelle adresse sur le niveau actif (/OE=0) et programmer cette adresse sur le niveau inactif (/OE=1).

Avantageusement, en cas de vérification de programmation, l'adresse programmée sur un front inactif (/OE=1) est lue pour vérification sur le front actif suivant du signal de validation /OE (/OE=0).

Le procédé de l'invention permet de supprimer les cycles d'écritures des codes instructions, sauf le premier et les cycles d'écritures de la donnée à programmer, sauf le premier, quand une même donnée doit être programmée en plusieurs adresses. Il en découle un gain de temps particulièrement important, notamment pour les programmations d'une grande partie de la mémoire.

## Revendications

1. Procédé de programmation d'une donnée D dans une mémoire électriquement programmable en circuit intégré comportant un bus d'entrée/sortie de données (D-BUS/S-MEM), un bus d'adresse (A-BUS), un registre de commande (3) de modes de séquencement d'instructions et un signal de validation (/OE), ce signal validant le bus (S-MEM) de sortie de données sur un état actif caractérisé en ce que lorsque le registre de commande (3) reçoit une instruction de programmation uniforme (IF), il envoie un signal de mode de séquencement de programmation uniforme (F) pour que le signal de validation (/OE) commande la programmation de la donnée D à une adresse mémoire présente sur le bus d'adresse sur l'état inactif (/OE=1) et commande l'arrêt de la programmation sur l'état actif (/OE=O).

2. Procédé de programmation selon la revendication 1, caractérisé en ce que l'on écrit une première adresse (M0) à programmer sur le bus d'adresse (A-BUS), et la donnée D dans un registre de données (2) pour programmer cette première adresse (M0), le signal de validation (/OE) étant à l'état inactif (/OE=1), le passage à l'état actif du signal de validation (/OE) arrêtant la programmation de la première adresse (M0).

3. Procédé de programmation selon la revendication 2, caractérisé en ce qu'une nouvelle adresse (M1) à programmer est écrite sur le bus d'adresse (A-BUS) pendant le niveau actif du signal de validation (/OE=0), et programmée avec la donnée D sur le niveau inactif suivant du signal de validation (/OE).

4. Procédé de programmation selon la revendication 2 ou 3, caractérisé en ce que l'adresse programmée sur un niveau inactif est lue sur le niveau actif suivant du signal de validation (/OE).

5. Procédé de programmation selon la revendication 4, caractérisé en ce qu'une adresse est écrite sur le bus d'adresse sur un niveau actif du signal de validation (/OE) après une lecture pendant ce niveau actif de l'adresse programmée pendant le niveau inactif précédent.

6. Mémoire électriquement programmable en circuit intégré comportant un bus d'adresse, un bus d'entrée/sortie (D-BUS/S-MEM) de données et un registre de commande (3) de mode de séquencement d'instruction, et recevant un signal de validation (/OE), ce signal validant le bus de sortie de données (S-MEM) sur un état actif et un signal d'autorisation d'écriture (/WE) pour générer une horloge (D-CLK) de mémorisation de données dans un registre (2) de données, une horloge (A-CLK) de mémorisation d'adresse dans un décodeur (DEC) de la mémoire et une horloge (I-CLK) de mémorisation d'instructions dans le registre de commande (3), caractérisée en ce qu'elle comporte en outre des moyens (32, 33) pour délivrer un signal de commande de programmation uniforme (P-KF) recevant en entrée un signal de mode de programmation uniforme (F), l'horloge (D-CLK) de mémorisation de données et le signal de validation (/OE) et délivrant en sortie (330) un niveau actif du signal de commande de programmation uniforme (P-KF=1) sur un niveau inactif du signal de validation (/OE= 0) et un niveau inactif du signal de commande de programmation uniforme (P-KF=0) sur un niveau actif du signal de validation (/OE = 1), le signal de mode de programmation uniforme (F) étant délivré par le registre de commande (3).

7. Mémoire selon la revendication 6, caractérisée en ce qu'elle comprend en outre des moyens (16) pour imposer un niveau permanent sur l'horloge de mémorisation des adresses (A-CLK), ces moyens étant commandés par le signal de mode de programmation uniforme (F).

8. Mémoire selon la revendication 6 ou 7, caractérisée en ce qu'elle comporte des moyens (40) pour délivrer un signal de commande de lecture (T-K), ces moyens recevant en entrée le signal de mode de programmation uniforme (F) et le signal de validation (/OE) en délivrant un signal de commande de lecture (T-K) actif sur le niveau actif du signal de validation (/OE).

9. Mémoire selon l'une des revendications 6 à 8, caractérisée en ce que les moyens pour délivrer une commande de programmation uniforme (P-KP) comportent une bascule (32) recevant en entrée le signal de mode de programmation uniforme (F), en horloge, l'horloge (D-CLK) de mémorisation de données et délivrant une sortie (320) connectée en entrée d'une porte ET (33), l'autre entrée de la porte ET recevant le signal de validation (/OE), la sortie de la porte ET (33) délivrant le signal de commande de programmation uniforme (P-KF).

## Patentansprüche

1. Verfahren zur Programmierung einer Dateneinheit D in einem elektrisch programmierbaren Speicher in einem integrierten Schaltkreis mit einem Eingangs-/Ausgangs-Datenbus (D-BUS/S-MEM), einem Adreßbus (A-BUS), einem Befehlsregister (3) für Moden der Abfolge von Befehlen und eines Freigabesignals (/OE), wobei dieses Signal den Datenausgangsbus (S-MEM) in einem aktiven Zustand freigibt, dadurch gekennzeichnet, daß beim Empfang eines Befehls zur uniformen Programmierung (IF) durch das Steuerregister (3) dieses ein Signal für den Mode des Ablaufs der uniformen Programmierung (IF) abschickt, damit das Freigabesignal (/OE) die Programmierung der Dateneinheit D bei einer Speicheradresse steuert, die auf dem Adreßbus in dem inaktiven Zustand (/OE=1) anliegt, und die Unterbrechung der Programmierung in dem aktiven Zustand (/OE=0) steuert.

2. Verfahren der Programmierung nach Anspruch 1, dadurch gekennzeichnet, daß eine erste zu programmierende Adresse (M0) auf den Adreßbus (A-BUS) und die Dateneinheit D in ein Datenregister (2) geschrieben wird, um diese erste Adresse (M0) zu programmieren, wobei das Freigabesignal (/OE) sich im inaktiven Zustand (/OE=1) befindet, der Übergang in den aktiven Zustand des Freigabesignals (/OE) die Programmierung der ersten Adresse (M0) unterbricht.

3. Verfahren der Programmierung nach Anspruch 2, dadurch gekennzeichnet, daß eine neue zu programmierende Adresse (M1) auf den Adreßbus (A-BUS) während des aktiven Pegels des Freigabesignals (/OE=0) geschrieben wird und programmiert wird mit der Dateneinheit D auf dem inaktiven Pegel nach dem Freigabesignal (/OE).

4. Verfahren der Programmierung nach Anspruch 2 oder 3, dadurch gekennzeichnet, daß die auf einen inaktiven Pegel programmierte Adresse auf dem aktiven Pegel nach dem Freigabesignal (/OE) gelesen wird.

5. Verfahren der Programmierung nach Anspruch 4, dadurch gekennzeichnet, daß eine Adresse auf den Adreßbus auf einem aktiven Pegel des Freigabesignals (/OE) nach einem Lesen während des aktiven Pegels der programmierten Adresse bei dem vorangehenden inaktiven Pegel geschrieben wird.

6. Elektrisch programmierbarer Speicher in einem integrierten Schaltkreis mit einem Adreßbus, einem Eingangs-/Ausgangs-Datenbus (D-BUS/S-MEM) und einem Befehlsregister (3) für den Mode der Abfolge eines Befehls auch ein Freigabesignal (/OE) empfangend, wobei dieses Signal den Datenausgangsbus (S-MEM) auf einem aktiven Zustand freigibt, und ein Schreibfreigabesignal (/WE) zum Erzeugen eines Taktsignals (D-CLK) zum Abspeichern von Daten in einem Datenregister (2), einen Taktgeber (A-CLK) zum Abspeichern der Adresse in einem Dekoder (DEC) des Speichers und einen Taktgeber (I-CLK) zum Abspeichern von Befehlen in dem Befehlsregister (3), dadurch gekennzeichnet, daß er außerdem Vorrichtungen (32, 33) zum Ausgeben eines Signals zum Steuern der uniformen Programmierung (P-KF), die am Eingang ein Modesignal für die uniforme Programmierung (F) empfangen, einen Taktgeber (D-CLK) zum Abspeichern von Daten und des Freigabesignals (/OE) und zum Ausgeben am Ausgang (330) eines aktiven Pegels des Signals zum Steuern der uniformen Programmierung (P-KF=1) auf einem inaktiven Pegel des Freigabesignals (/OE=0) und eines inaktiven Pegels des Signals zur Steuerung der uniformen Programmierung (P-KF=0) auf einem aktiven Pegel des Freigabesignals (/OE=1) umfaßt, wobei das Modesignal der uniformen Programmierung (F) ausgegeben wird durch das Befehlsregister (3).

7. Speicher nach Anspruch 6, dadurch gekennzeichnet, daß er außerdem Vorrichtungen (16) umfaßt, um einen durchgehenden Pegel dem Taktgeber zum Abspeichern von Adressen (A-CLK) aufzuzwingen, wobei diese Vorrichtungen gesteuert werden durch das Modesignal der uniformen Programmierung (F).

8. Speicher nach Anspruch 6 oder 7, dadurch gekennzeichnet, daß er Vorrichtungen (40) umfaßt, um ein Lesesteuersignal (T-K) auszugeben, wobei diese Vorrichtungen am Eingang das Modesignal der uniformen Programmierung (F) und das Freigabesignal (/OE) empfangen, wobei sie ein Lesesteuersignal (T-K) ausgeben, das aktiv auf dem aktiven Pegel des Freigabesignals (/OE) ist.

9. Speicher nach einem der Ansprüche 6 bis 8, dadurch gekennzeichnet, daß die Vorrichtungen zum Ausgeben eines Befehls zur uniformen Programmierung (P-KP) eine Kippstufe (32) beinhalten, die am Eingang des Modesignals der uniformen Programmierung (F), am Taktgeber den Taktgeber (D-CLK) zum Abspeichern von Daten empfängt und ein Ausgangssignal (320) ausgibt, das mit dem Eingang eines UND-Gatters (33) verbunden ist, wobei der andere Eingang des UND-Gatters das Freigabesignal (/OE) empfängt, wobei der Ausgang des UND-Gatters (33) das Signal zur Steuerung der uniformen Programmierung (P-KF) ausgibt.

## Claims

1. Method of programming a data item D into an electrically programmable integrated-circuit memory having a data input/output bus (D-BUS/S-MEM), an address bus (A-BUS), a register (3) for controlling instruction sequencing modes and an enable signal (/OE), this signal enabling the data output bus (S-MEM) at an active state, characterised in that, when the control register (3) receives a uniform programming instruction (IF), it sends a uniform programming sequencing mode signal (F) so that the enable signal (/OE) controls the programming of the data item D at a memory address present on the address bus at the inactive state (/OE=1) and controls the stoppage of the programming at the active state (/OE=0).

2. Programming method according to Claim 1, characterised in that a first address (M0) to be programmed is written on the address bus (A-BUS), and the data item D in a data register (2) for programming this first address (M0), the enable signal (/OE) being at the inactive state (/OE=1), the change to the active state of the enable signal (/OE) stopping the programming of the first address (M0).

3. Programming method according to Claim 2, characterised in that a new address (M1) to be programmed is written on the address bus (A-BUS) during the active level of the enable signal (/OE=0), and programmed with the data item D on the following inactive level of the enable signal (/OE).

4. Programming method according to Claim 2 or 3, characterised in that the address programmed on an inactive level is read on the following active level of the enable signal (/OE).

5. Programming method according to Claim 4, characterised in that an address is written on the address bus at an active level of the enable signal (/OE) after a reading during this active level of the address program during the previous inactive level.

6. Electrically programmable integrated-circuit memory having an address bus, a data input/output bus (D-BUS/S-MEM) and a register (3) for controlling the instruction sequencing mode, and receiving an enable signal (/OE), this signal enabling the data output bus (S-MEM) at an active state and a write enable signal (/WE) for generating a clock (D-CLK) for storing data in a data register (2), a clock (A-CLK) for storing an address in a decoder (DEC) of the memory and a clock (I-CLK) for storing instructions in the control register (C), characterised in that it also has means (32, 33) for delivering a uniform programming control signal (P-KF) receiving as an input a uniform programming mode signal (F), the data storage clock (D-CLK) and the enable signal (/OE) and delivering as an output (330) an active level of the uniform programming control signal (P-KF=1) at an inactive level of the enable signal (/OE=0) and an inactive level of the uniform programming control signal (P-KF=0) at an active level of the enable signal (/OE=1), the uniform programming mode signal (F) being delivered by the control register (3).

7. Memory according to Claim 6, characterised in that it also comprises means (16) for imposing a permanent level on the address storage clock (A-CLK), these means being controlled by the uniform programming mode signal (F).

8. Memory according to Claim 6 or 7, characterised in that it has means (40) for delivering a read control signal (T-K), these means receiving as an input the uniform programming mode signal (F) and the enable signal (/OE), delivering an active read-control signal (D-K) at the active level of the enable signal (/OE).

9. Memory according to one of Claims 6 to 8, characterised in that the means for delivering a uniform programming command (P-KP) include a flip-flop (32) receiving as an input the uniform programming mode signal (F), as a clock, the data storage clock (D-CLK) and delivering an output (320) connected as an input:to an AND gate (33), the other input of the AND gate receiving the enable signal (/OE), the output of the AND gate (33) delivering the uniform programming control signal (P-KF).
